# EUROPEAN PATENT SPECIFICATION

(11) **EP 0 733 259 B1**
(45) Date of publication and mention of the grant of the patent: **23.02.2000**
(21) Application number: 95902133.8
(22) Date of filing: 07.12.1994
(51) Int. Cl.: G11C 7/00

(54) **IMPROVED FIELD MEMORY**
VERBESSERTER FELDSPEICHER
MEMOIRE DE CHAMP AMELIOREE

(30) Priority: 07.12.1993 IT RM930810; 07.12.1993 IT RM930811; 07.12.1993 IT RM930812
(43) Date of publication of application: 25.09.1996
(73) Proprietor: TEXAS INSTRUMENTS ITALIA S.p.A., 67051 Avezzano (AQ) (IT); TEXAS INSTRUMENTS INCORPORATED, Dallas Texas 75265 (US)
(72) Inventor: IMONDI, Giuliano, I-02100 Rieti (IT); MENICHELLI, Stefano, I-00173 Roma (IT); SANSONE, Carlo, I-67100 L'Aquila (IT)
(74) Representative: Legg, Cyrus James Grahame
(86) International application number: EP9404071
(87) International publication number: WO9516266

(56) References cited:
- EP-A- 0 137 318
- US-A- 3 623 020
- US-A- 3 898 632
- US-A- 3 967 251
- US-A- 5 027 318
- PATENT ABSTRACTS OF JAPAN vol. 6 no. 13 (P-99) [891] ,26 January 1982 & JP,A,56 137581 (TOSHIBA) 27 October 1981,

## Description

This invention relates to field memories (FMEM) including those using, for example, dynamic random access memory (DRAM) technology.

A dynamic memory cell is one which stores data as charge, or absence of charge, on a capacitor. Typically the cell isolates the capacitor from the data (bit) line with a transistor switch such that when no read or write operation is required there is essentially no power demand to maintain the data. However, normal leakage normally requires that the charge be periodically restored. This periodic restoration of the charge is known as the refresh process.

A Field Memory (FMEM) is sequential-access memory, of the First-in First out (FIFO) type. Currently, the central memory of a FMEM has a typical capacity of one to four megabit (1-4Mb) and, to achieve high integration of densities, consists, for example, of an array of dynamic cells derived directly from DRAM technology.

FMEM's are devices in which the read and write operations may be asynchronous. Two distinct uncorrelated clocks may be used. Alternatively, the read and write operations may be synchronised using a single clock.

A very important feature of all FMEM is their high operating speed with clock frequencies between 30MHz and 50MHz, for example.

The technology employed has a determining influence on the general architecture of FMEM; in particular on the physical arrangement of the registers within the device.

US-A-5 027 318 discloses a circuit for storing bits of successive datawords in respective memory chips. Successive bits are fed through a shift register and are transferred periodically in parallel to a D-register. They are then transferred to a RAM chip over a bus. The bits are read out of the memory by being transferred periodically in parallel over the same bus to another shift register from which they are supplied in succession.

The present invention provides an improved field memory having an improved architecture. Such an improved architecture results in a more efficient structure and layout on integrated circuit which forms the device.

The present invention also provides an improved implementation of the input enable function.

According to the present invention there is provided a field memory integrated circuit comprising:
a memory array for storing datawords, said memory array being divided into a plurality of memory blocks (30,31);
a plurality of first buffers for receiving the datawords into the field memory; and
a plurality of second buffers for supplying the datawords from the field memory;
the field memory being so arranged that bits located in a particular position in the datawords are stored in a particular one of the memory blocks;
the field memory further comprising:
a plurality of first circuits, each connected to a particular one of the memory blocks, each of said first circuits being capable of transferring bits of said datawords to the memory block connected to that first circuit;
a plurality of second circuits, each connected to a particular one of the memory blocks, each of said second circuits being capable of transferring bits of said datawords from the memory block connected to that second circuit;
first data buses for connecting each of said first circuits to the memory block connected to that first circuit and for transferring bits of the datawords to that memory block; and
second data buses for connecting each of said second circuits to the memory block connected to that second circuit and for transferring bits of the datawords to that memory block;
said first data buses being distinct from said second data buses.

A field memory in accordance with the present invention may be described as a distributed architecture, as the bits of the word are "distributed" among the blocks of the array. Distributed architecture is more efficient than conventional technology in solving the problem of transferring data between the input/output (I/O) buffers and the internal registers of the buffer.

In one embodiment of the present invention, the field memory is divided into blocks having registers, with each bit uniquely associated with one register bank.

In order that features and advantages of the present invention may be more fully appreciated, embodiments will now be described by way of example only and with reference to the accompanying drawings of which:-
- Figure 1: is an architectural diagram of a field memory device,
- Figure 2: is a diagram to show the arrangement of one block of central memory,
- Figure 3: is an architectural diagram showing distributed architecture,
- Figure 4: is an architectural diagram showing a further example of an embodiment employing distributed architecture,
- Figure 5.1: is a transfer gate arrangement,
- Figure 5.2: is a timing diagram.

By way of example, the embodiments described refer to field memories employing in its original form conventional technology, such as 4Mb DRAM technology. The concept of distributed architecture would, however, benefit other applications and technology, for example, both current ad future 16Mb DRAM technology. This embodiment illustrates the distributed architectural solution as applied to the problem of transferring data between the I/O buffers and the registers. The architecture described solves the transfer problem more efficiently than prior technology.

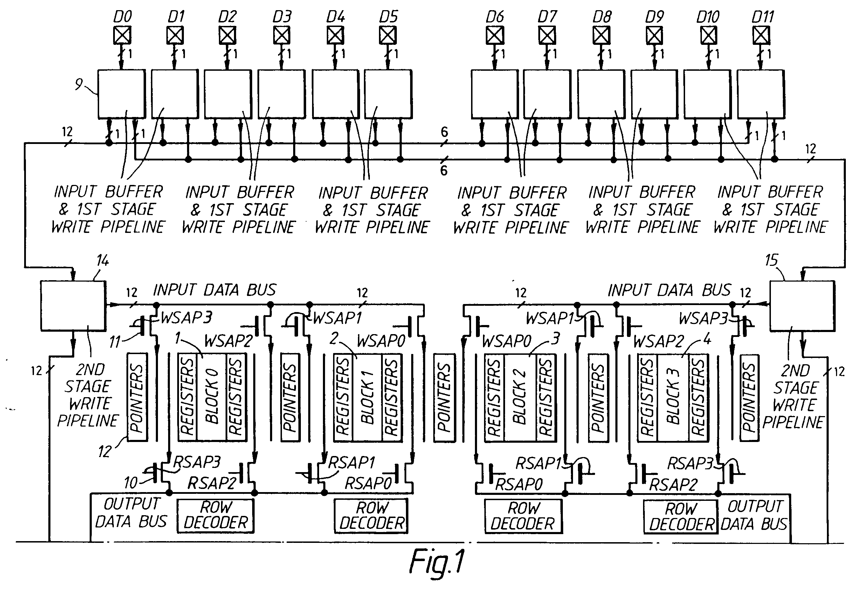

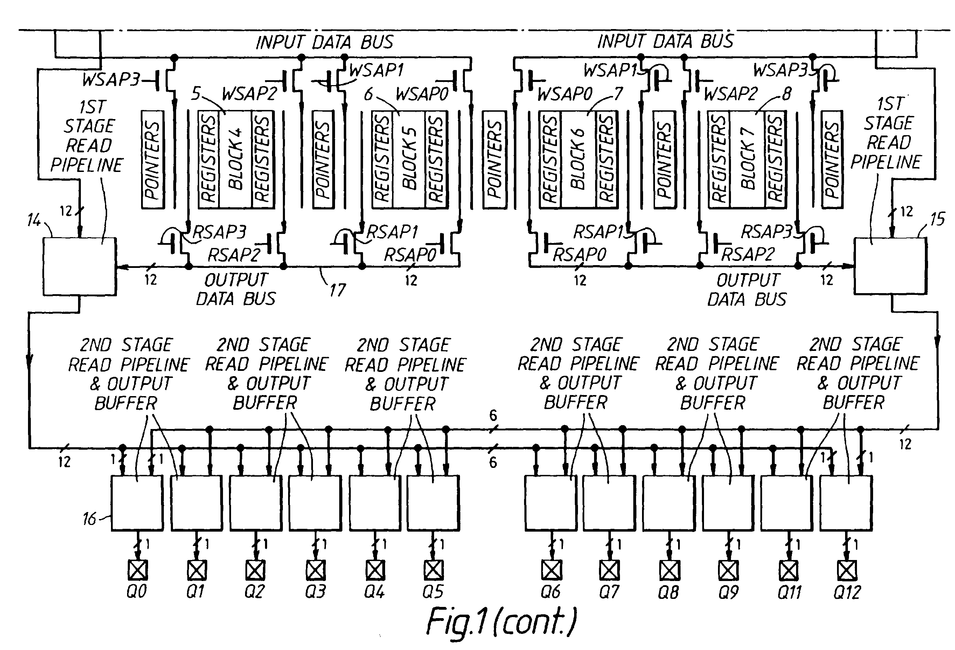

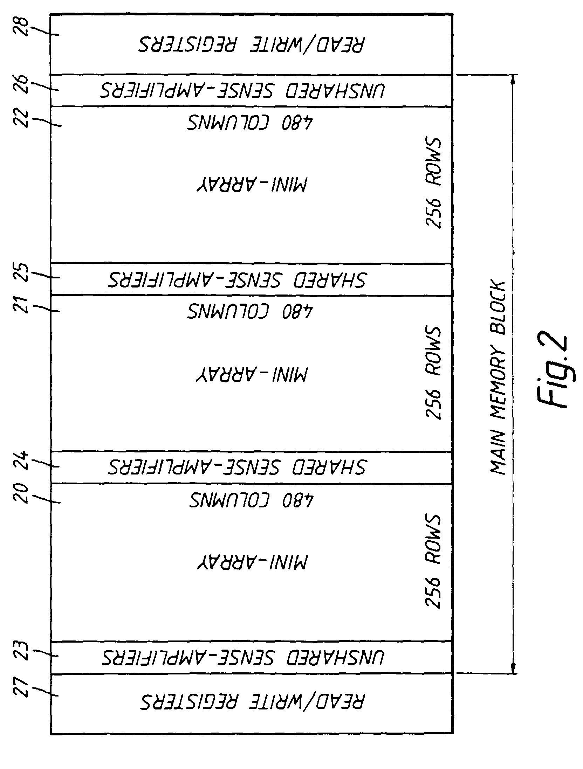

The Field Memory, shown as a block diagram in Figure 1, has a central memory which is sub-divided into 8 blocks, numbered 1 to 8 (Figure 1). Each block, as shown in Figure 2, contains three mini-arrays (20,21,22) with associated sense-amplifiers (23,24,25,26). The outer mini-arrays are flanked by read/write registers (27,18). In total there are 16 banks of registers (2 x 8 blocks). In one embodiment each mini-array is arranged as 256x480 columns (122,880 bits).

Each bank contains a sufficient number of registers, for both read and write modes, to store five words. This gives a total capacity for the buffer memory of 80 words (16x5).

The 12 bits of a word are stored in adjacent registers, which require input and output buses (respectively 16,17), both twelve bits wide, beside each bank of registers (Figure 1). These buses have buffers on each input, such as buffer 9 having an input pad DO. The outputs are also buffered (such as by buffer 16).

The register banks are addressed using selectors which select 4 banks out of the 16. These selectors are identified, in Figure 1, as SAPs. The SAPs are suffixed from 0 to 3 and prefixed W to indicate write mode such as WSAP 0, or R for read mode such as RSAP 0. Beside each register bank are pointers which select one of the five word options, such as pointer 12.

Using two pipelines (14,15), one for write and one for read mode, four words are addressed in parallel at a time. The write pipeline transfers data from the input buffers to the registers in parallel, thereby reducing the clock frequency by a factor of four. The read pipeline serialises the data transferred from the registers to output buffers, increasing the clock frequency by a factor of four.

The number N of words involved in each memory cycle, either in write or read mode, defines a time window. This window is expressed as N (the Number of words involved) x MCT (Minimum Cycle Time). The MCT is the time, within which all 5 possible requests for access to the central memory can be met. These request for access are; "Reset Write", "Sequential Write", "Reset Read", "Sequential Read" and "Refresh".

Time sequencing of the central memory operations, and therefore "requests" is managed by an "arbiter" - the section of a multiprocessor network's operating system capable of resolving simultaneous system-resource requests.

Each and every access to the memory array involves all the cells in the row being addressed, although only a quarter of these cells are actually involved in the read or write operation. All cells are involved because block selectors select 1 sense-amplifier out of the 4 available, and connect it to the local register. The row addresses are contained in 3 counters, identified on figure 1 as "write row counter", "read row counter" and "refresh row counter". The refresh row address is incremented at every refresh cycle. The read row address is incremented every 4 read cycles and,similarly, the write row address is incremented every 4 write cycles, as a result of module 4 column addressing and sequential access.

It will be observed that the architecture described thus far takes no account of the "position" attribute of bits in an individual word. With reference to figure 1, there is no relation between the positions of the I/O pads (D,Q) and the position of the registers where the bits are stored. During transfer between the pipeline and the registers, the bits of a word are grouped into packets of twelve and transferred, regardless of their origin and/or destination, via a network of I/0 data buses, in which each bus has a width of twelve.

By contrast, in accordance with the present invention it is possible to associate the bits of the individual word with the register banks, connect the pipelines in "local mode" and considerably simplify the mechanism for addressing registers by for example, in the preliminary stage of planning the layout, taking account of the position of the registers in relation to the position of the I/0 pads.

To apply this principle within a distributed architecture efficiently, it is to be preferred if the number of blocks in the central memory is a function of the number of bits in the word. Conventional technology with eight memory blocks (figure 1) would accord well with words of length 8 or 16, for instance. However, 8 memory blocks are ill-suited to words with a length of 12, as in the architecture described.

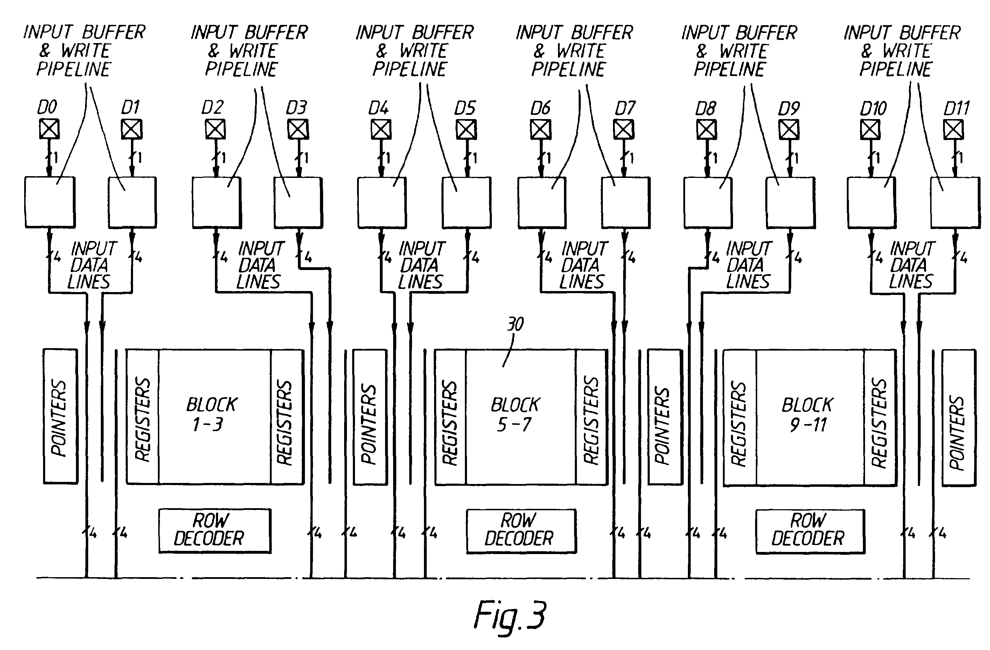

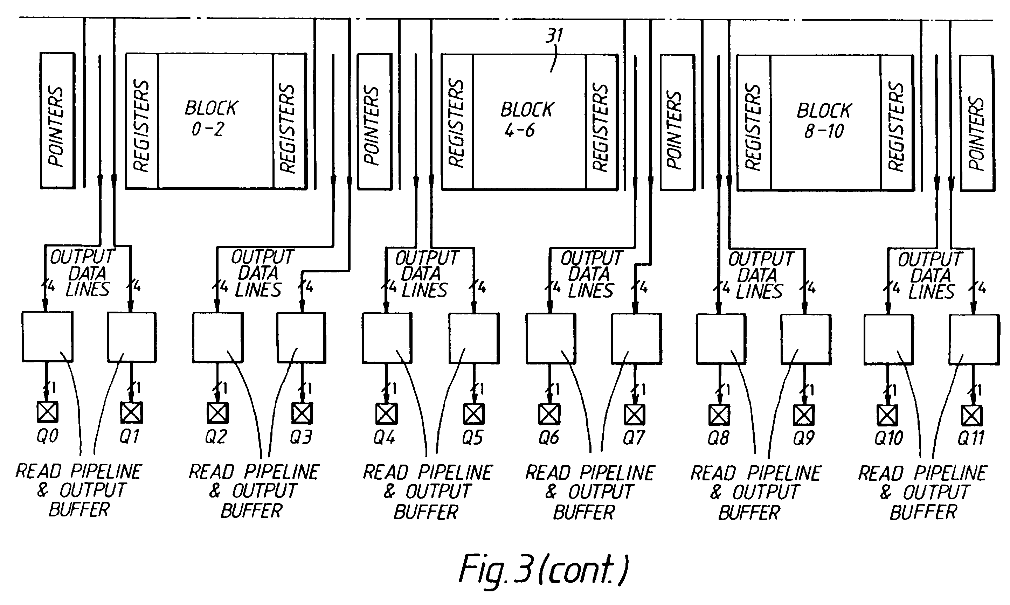

If the word length is fixed, in this example as 12, the central memory should be reorganised into either 12 or 6 blocks. The number of blocks becoming a function of the number of bits in the word. Utilising a 6 block architectural solution, according to this embodiment, the "distributed" architectural layout shown in figure 3 is obtained.

In the improved layout (figure 3), every bit of the word is uniquely associated with one register bank. For instance, in block 5-7 (30) are stored only the fifth and seventh bits of the word. Likewise, block 4-6 (31) stores just the fourth and sixth bits of the word. The "local" connections shown in figure 3 are achieved whilst maintaining parallelism of access to the registers equal to four in the embodiment. However, the network of I/0 data lines of this circuit (figure 3), based on the present invention is considerably simplified when compared with that of figure 1. For instance, the number of lines passing besides the register banks has been reduced by 50%; the horizontal I/0 data buses being eliminated.

Leaving the capacity of the buffer memory unchanged (80 words), the mechanism for addressing registers is enormously simplified, due to the elimination of one addressing level, ie: the level formerly controlled by the SAP selectors.

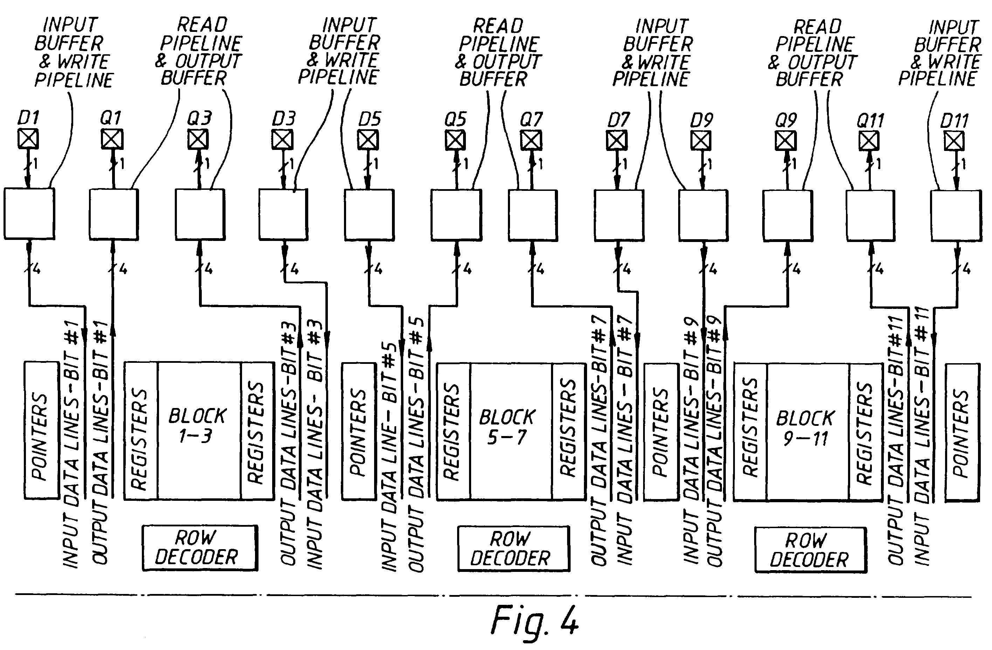

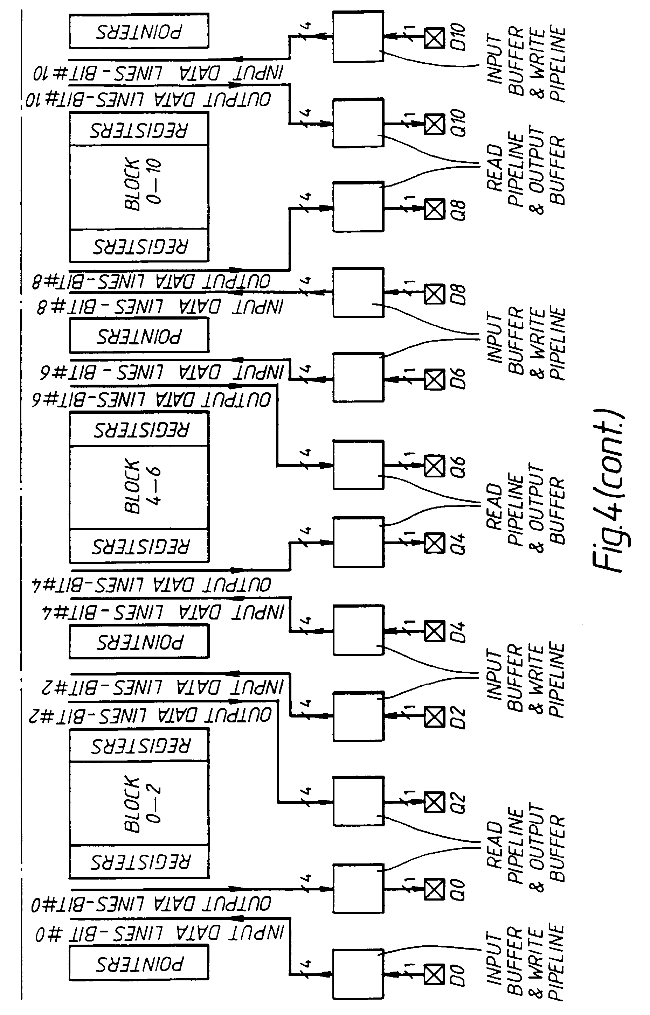

In a further embodiment of this invention by changing the arrangement of the pads it is possible to obtain the layout shown in figure 4, where the configuration of the I/0 data lines is even more efficient than achieved in figure 3.

Yet a further development of the circuit shown in figure 4 would derive another layout for devices which have their pads arranged horizontally along a central line, suitable for example for a lead over chip arrangement.

It is of note that the layouts shown in both figures 3 and 4, parallelism of registers of possibly less than 4 is likely to be sufficient, because the I/0 operations are extremely localised by the layout design, they are therefore less penalised by the speed of parasitic components necessitated by routing.

In the examples, for simplicity, as within figure 1 the presence of an Input Enabler (IE) has not been described. Indeed some FMEMs do not have IE at all.

Input Enable (IE) is the signal which establishes whether, or not, the word currently in input is to be stored in memory, or if the pre-existing item of data is to be left in place unchanged. Known as "masking", this process is performed at "registers level" in the example circuit (figure 1). This means that the IE information bit, associated with every word in input, is distributed wherever one or more bits of the word itself are stored. In the arrangement of figure 1, for the purpose of this description, the IE can be considered as the thirteenth bit of the word in input. Should it be considered desirable to take account of the "effective thirteenth bit" this can be achieved in figure 1 by increasing the width of the Input Data Buses from 12 to 13. To take account of the "thirteenth bit" within the architecture shown in figure 3 it is necessary to add a further 4 Input Data Lines. These lines can, however, be shared by two adjacent register banks, so the resulting embodiment remains more efficient than the corresponding prior art device.

One solution to obtain an IE function is where, when it is desirable to mask the input and the IE associated with the word therefore has a value of 0, the opening of the transfer gates which connect the word registers to the sense amplifiers is inhibited. By this inhibiting, the write cycle has the effect of writing in the array cells associated with the words which have their transfer gates closed, that is the words with an IE value of 1, simultaneously having the effect of performing a refresh cycle in the cells associated with the masked words, that is the words with an IE value of 0 and whose transfer gates are open.

In devices based on 1Mb technology, e.g. the TMS1070, the registers of the buffer memory are external to the central memory and located at the periphery. Therefore there are no layout problems, which would otherwise prevent write inhibition, at the level of the transfer gates connecting the word register to the sense amplifiers.

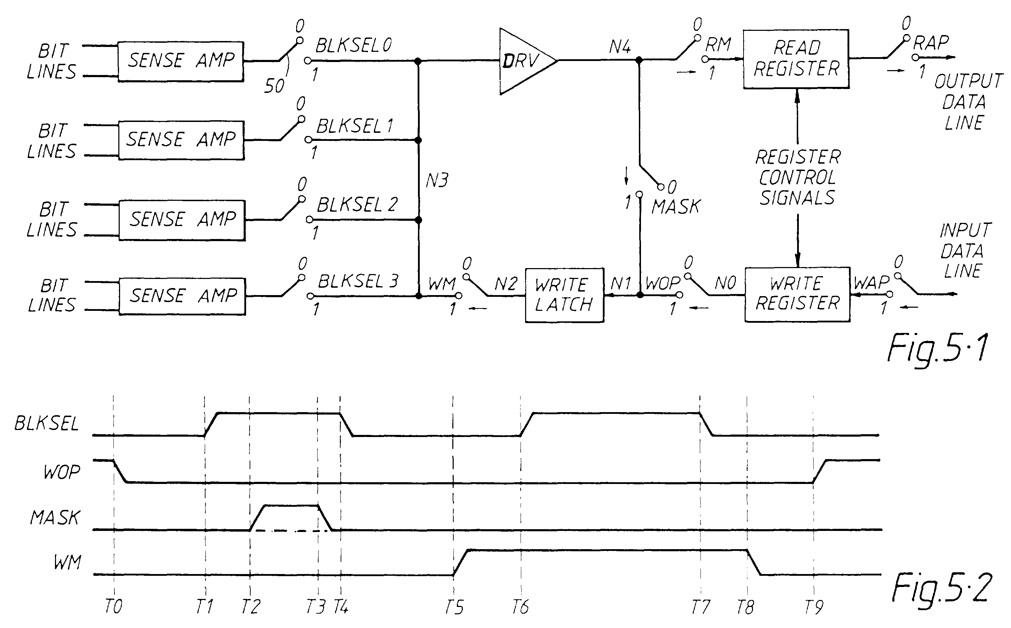

With 4Mb technology by contrast, the layout of the register occupies, vertically, the space of 4 sense amplifiers. During a memory cycle, every register is connected, via a transfer gate and with appropriate timings, to one of the 4 sense amplifiers associated with it. The selection of the sense amplifiers is controlled by 4 signals, called Block Select (BLKSEL) and shown in figure 5, numbered 0,1,2,3 and 4 - which open and close the transfer gates, such as gate 50 controlled by block select 0.

If the solution applied for the TMS1070 were considered for the 4Mb based device, control of the block selectors would need to be differentiated by word, and the control mechanism would have to take account of the IE value in order to inhibit or not, closure of the transfer gates associated with that.

Whilst this would yield an operational device, to be preferred is a methodology for implementing IE that does not significantly impinge on the core design.

The arrangement to be described performs, immediately prior to a write cycle, a read cycle followed by a choice, based on the value the IE, between the new item of data and the last item of data read by the central memory. The data choice, once selected, is immediately written, physically, into the central memory-using a normal write cycle.

This methodology would find immediate application for instance, in field memories based on 4Mb technology which having a complex layout regarding sense amplifiers and registers, would otherwise be both difficult and expensive to modify.

Input Enable (IE) is a signal which allocates to each word being input an information bit to establish whether or not the word is to be written to memory, the data already in memory will be left unchanged. The implementation will now be described with reference to figure 5.

To facilitate understanding of the operation of the embodiment figure 5 is a diagram of a section 5.1 of a register with its associated sense-amplifiers, the timings (5.2) are those which can be expressed from this or similar circuits, being representative of the type.

With every word, in addition to the twelve registers that store the bits, is associated a further register. This further register stores the value of the IE associated with the word. It is the register which, with appropriate timing, generates the MASK signal.

With reference to figure 5, at an instant TO all the N words of the buffer memory have been written. At this point, the control signal WOP (Write Operation) opens the corresponding switch isolating the "Write Latch" from the "Write Register". At the same time, a write request is sent to the arbiter.

The "Write Latch" holds data relating to the current write cycle, while the "Write Register" is made available for storing the subsequent item of data. As soon as possible, the arbiter initiates the write cycle, consisting of two consecutive cycles, a read cycle and a normal write cycle. The read cycle commences at time T1 when the sense-amplifiers have commutated in response to the data contained in the memory cells. Then, one of the BLKSEL's commutes to 1, and connects to node 4, via the driver (DRV).

On the basis of the IE value, at instant T2 the MASK signal is generated, which controls the switches of the 12 registers associated with the word. If MASK commutates to 1 (continuous line in figure 5.2, IE=0), the signal at node N4 is transmitted to node N1 and is stored in the Write Latch. In this case, the new item of data is replaced by the pre-existing one. If, on the other hand MASK, remains at 0 (broken line in figure 5.2, IE=1), the new data item will be written into the central memory, since the content of the Write Latch remains unchanged. At instant T4, BLKSEL returns to 0 and the Write Latch holds the result of the choice made - on the basis of the MASK value and therefore of the IE - between the new data item and the data item held in the central memory.

It is therefore now possible to begin the normal write cycle that completes the write cycle. At instant T5, the WM (Write Memory) commutates to 1, directing node N3 to the value of the data item stored in the Write Latch.

At instant T6, the BLKSEL, equal to that used for the preceding read cycle, commutes again to 1 and forces the sense amplifier to commutate in accordance with the signal present at node N3. Subsequently, the cells of the array are rewritten, the BLKSEL returns to 0, and the WM commutates to 0. Finally, the WOP signal switches back to 1, indicating the end of the write cycle.

The methodology described above has the advantage, when compared with other methods, of being suitable for a 4Mb technology device, as in this methodology the duration of the write cycle is double that of a normal write cycle.

| Table for Figure 1 | |
|---|---|
| MREQ | Memory Request |
| WMREQ | Write Memory Request (Reset and Sequential) |
| RHMREQ | Refresh Memory Request |
| RMREQ | Read Memory Request (Reset and Sequential) |
| WPCS | Write Pipeline Control Signals |
| RPCS | Read Pipeline Control Signals |
| WMC | Write Mini-Cache |
| WSCK | Write Shift-Clock |
| PTOS | Parallel Transfer One Shot |
| RMC | Read Mini-Cache |
| RSCK | Read Shift Clock |

| Table for Figure 5 | |
|---|---|
| BLKSEL | Block Select |
| WOP | Write Operation |
| WM | Write Memory |
| WAP | Write Address Pointer |
| RAP | Read Address Pointer |
| RM | Read Memory |

## Claims

1. A field memory integrated circuit comprising:
a memory array for storing datawords, said memory array being divided into a plurality of memory blocks (30,31);
a plurality of first buffers for receiving the datawords into the field memory; and
a plurality of second buffers for supplying the datawords from the field memory;
the field memory being so arranged that bits located in a particular position in the datawords are stored in a particular one of the memory blocks;
the field memory further comprising:
a plurality of first circuits, each connected to a particular one of the memory blocks, each of said first circuits being capable of transferring bits of said datawords to the memory block connected to that first circuit;
a plurality of second circuits, each connected to a particular one of the memory blocks, each of said second circuits being capable of transferring bits of said datawords from the memory block connected to that second circuit;
first data buses for connecting each of said first circuits to the memory block connected to that first circuit and for transferring bits of the datawords to that memory block; and
second data buses for connecting each of said second circuits to the memory block connected to that second circuit and for transferring bits of the datawords to that memory block;
said first data buses being distinct from said second data buses.

2. A field memory as claimed in claim 1, wherein each of said plurality of first circuits comprises a write register.

3. A field memory as claimed in claim 1 or claim 2, wherein each of said plurality of said second circuits comprises a read register.

4. A field memory as claimed in any preceding claim, wherein the number of memory blocks (30,31) is selected to be a function of the number of bits in said datawords.

5. A field memory as claimed in any preceding claim, wherein each memory block is capable of storing bits from a plurality of particular positions in said datawords.

6. A field memory as claimed in claim 5, wherein each memory block (30,31) is arranged for storing non-adjacent bits in said datawords.

7. A field memory as claimed in any one of claims 1 to 4 wherein each memory block only stores bits from a single position in said datawords.

8. A field memory as claimed in any preceding claim, wherein the first buffers (D0-D11) include pipeline latch circuitry.

9. A field memory as claimed in any preceding claim, wherein the second buffers (Q0-Q11) include pipeline latch circuitry.

10. A field memory as claimed in any preceding claim, wherein each of said plurality of second circuits is further capable of transferring bits of a dataword stored in a memory block (30,31) to an associated one of the second buffers (Q0-Q11).

11. A field memory as claimed in any one of claims 8 to 10, wherein each bit of said dataword is loaded into the memory block via only one set of pipeline latch circuitry.

12. A field memory as claimed in any preceding claim, wherein each first buffer (D0-D11) is coupled to an input terminal, each input terminal being disposed adjacent to a corresponding one of the memory blocks (30,31) in which the bit of the dataword is to be stored.

13. A field memory as claimed in any preceding claim, wherein the second buffer (Q0-Q11) is coupled to an output terminal, each output terminal being disposed adjacent to a corresponding one of the memory blocks (30,31) in which a bit of the dataword is to be stored.

14. A field memory as claimed in any preceding claim, wherein the input terminal and the output terminal connected to the memory block (30,31) associated with a bit of a dataword are adjacent.

15. A field memory as claimed in any preceding claim, wherein the field memory constitutes a packaged device.

16. A field memory as claimed in claim 15, wherein the packaged device comprises a lead-over-chip (LOC) package.

17. A field memory as claimed in any preceding claim further comprising: a masked input enable (IE) arrangement.

## Patentansprüche

1. Feldspeicher-IC mit
einer in mehrere Speicherblöcke (30, 31) unterteilten Speichermatrix zum Speichern von Datenwörtern;
mehreren ersten Puffern zum Aufnehmen der Datenwörter in den Feldspeicher; und
mehreren zweiten Puffern zum Ausgeben der Datenwörter aus dem Feldspeicher;
wobei der Feldspeicher so aufgebaut ist, daß Bits, die an einer bestimmten Position in den Datenwörtern liegen, in einem bestimmten Speicherblock gespeichert werden; und
wobei der Feldspeicher darüber hinaus
mehrere erste Schaltungen, von denen jede mit einem bestimmten Speicherblock verbunden ist und Bits aus den Datenwörtern zu dem Speicherblock übertragen kann, der mit dieser ersten Schaltung verbunden ist;
mehrere zweite Schaltungen, von denen jede mit einem bestimmten Speicherblock verbunden ist und Bits aus den Datenwörtern von dem Speicherblock übertragen kann, der mit dieser zweiten Schaltung verbunden ist;
erste Datenbusse, die dazu dienen, jede der ersten Schaltungen mit dem Speicherblock zu verbinden, der mit der ersten Schaltung verbunden ist, und Bits aus den Datenwörtern zu diesem Speicherblock zu übertragen; und
zweite Datenbusse umfaßt, die dazu dienen, jede der zweiten Schaltungen mit dem Speicherblock zu verbinden, der mit der zweiten Schaltung verbunden ist, und Bits aus den Datenwörtern zu diesem Speicherblock zu übertragen;
wobei sich die ersten Datenbusse von den zweiten Datenbussen unterscheiden.

2. Feldspeicher nach Anspruch 1, bei dem jede der mehreren ersten Schaltungen ein Schreibregister umfaßt.

3. Feldspeicher nach Anspruch 1 oder Anspruch 2, bei dem jede der mehreren zweiten Schaltungen ein Leseregister umfaßt.

4. Feldspeicher nach einem der vorhergehenden Ansprüche, bei dem die Anzahl an Speicherblöcken (30, 31) so ausgewählt ist, daß sie von der Anzahl der Bits in den Datenwörtern abhängt.

5. Feldspeicher nach einem der vorhergehenden Ansprüche, bei dem jeder Speicherblock Bits von mehreren bestimmten Positionen in den Datenwörtern speichern kann.

6. Feldspeicher nach Anspruch 5, bei dem jeder Speicherblock (30, 31) so ausgebildet ist, daß er nichtnebeneinanderliegende Bits in den Datenwörtern speichern kann.

7. Feldspeicher nach einem der Ansprüche 1 bis 4, bei dem jeder Speicherblock nur Bits von einer einzigen Position in den Datenwörtern speichert.

8. Feldspeicher nach einem der vorhergehenden Ansprüche, bei dem die ersten Puffer (D0-D11) eine Pipeline-Zwischenspeicher-Schaltungsanordnung umfassen.

9. Feldspeicher nach einem der vorhergehenden Ansprüche, bei dem die zweiten Puffer (Q0-Q11) eine Pipeline-Zwischenspeicher-Schaltungsanordnung umfassen.

10. Feldspeicher nach einem der vorhergehenden Ansprüche, bei dem jede der mehreren zweiten Schaltungen darüber hinaus Bits aus einem Datenwort, die in einem Speicherblock (30, 31) gespeichert sind, zu einem zugeordneten zweiten Puffer (Q0-Q11) übertragen kann.

11. Feldspeicher nach einem der Ansprüche 8 bis 10, bei dem jedes Bit des Datenworts über nur eine Pipeline-Zwischenspeicher-Schaltungsanordnungsgruppe in den Speicherblock geladen wird.

12. Feldspeicher nach einem der vorhergehenden Ansprüche, bei dem der erste Puffer (D0-D11) mit einem Eingangsanschluß verbunden ist, wobei jeder Eingangsanschluß neben einem entsprechenden Speicherblock (30, 31) angeordnet ist, in dem das Bit aus dem Datenwort gespeichert werden soll.

13. Feldspeicher nach einem der vorhergehenden Ansprüche, bei dem der zweite Puffer (Q0-Q11) mit einem Ausgangsanschluß verbunden ist, wobei jeder Ausgangsanschluß neben einem entsprechenden Speicherblock (30, 31) angeordnet ist, in dem ein Bit aus dem Datenwort gespeichert werden soll.

14. Feldspeicher nach einem der vorhergehenden Ansprüche, bei dem der Eingangsanschluß und der Ausgangsanschluß, die mit dem einem Bit aus einem Datenwort zugeordneten Speicherblock (30, 31) verbunden sind, nebeneinanderliegen.

15. Feldspeicher nach einem der vorhergehenden Ansprüche, der als gekapselter Baustein ausgeführt ist.

16. Feldspeicher nach Anspruch 15, bei dem der gekapselte Baustein ein Gehäuse mit über dem Chip angebrachten Anschlußpins (LOC-Gehäuse) umfaßt.

17. Feldspeicher nach einem der vorhergehenden Ansprüche, der darüber hinaus eine Anordnung zur maskierten Eingabeaktivierung (IE) umfaßt.

## Revendications

1. Circuit intégré de mémoire de trames comprenant:
un réseau de mémoire pour mémoriser des mots de données, ledit réseau de mémoire étant subdivisé en une pluralité de blocs de mémoire (30,31) ;
une pluralité de premiers tampons servant à recevoir les mots de données dans la mémoire de trames ; et
une pluralité de secondes tampons servant à délivrer les mots de données à partir de la mémoire de trames ;
la mémoire de trames étant agencée de telle sorte que des bits situés dans une position particulière dans les mots de données sont mémorisés dans l'un particulier des blocs de mémoire ;
la mémoire de trames comprenant en outre:
une pluralité de premiers circuits, qui sont connectés chacun à l'un particulier des blocs de mémoire, chacun desdits premiers circuits étant à même de transférer des bits desdits mots de données au bloc de mémoire connecté à ce premier circuit ;
une pluralité de seconds circuits, dont chacun est connecté à l'un particulier des blocs de mémoire, chacun desdits seconds circuits étant à même de transférer des bits desdits mots de données à partir du bloc de mémoire connecté à ce second circuit ;
des premiers bus de transmission de données pour connecter chacun desdits premiers circuits au bloc de mémoire connecté à ce premier circuit pour transférer des bits des mots de données à ce bloc de mémoire ; et
des seconds bus de transmission de données pour connecter chacun desdits seconds circuits au bloc de mémoire connecté à ce second circuit et pour transférer des bits des mots de données à ce bloc de mémoire;
lesdits premiers bus de transmission de données étant distincts desdits seconds bus de transmission de données.

2. Mémoire de trames selon la revendication 1, dans laquelle chacun de ladite pluralité de premiers circuits comprend un registre d'écriture.

3. Mémoire de trames selon la revendication 1 ou la revendication 2, dans laquelle chacun de ladite pluralité desdits seconds circuits comprend un registre de lecture.

4. Mémoire de trames selon l'une quelconque des revendications précédentes, dans laquelle le nombre de blocs de mémoire (30,31) est choisi de manière à être une fonction du nombre de bits dans lesdits mots de données.

5. Mémoire de trames selon l'une quelconque des revendications précédentes, dans laquelle chaque bloc de mémoire peut mémoriser des bits à partir d'une pluralité de positions particulières dans lesdits mots de données.

6. Mémoire de trames selon la revendication 5, dans laquelle chaque bloc de mémoire (30,31) est agencé de manière à mémoriser des bits non adjacents dans lesdits mots de données.

7. Mémoire de trames selon l'une quelconque des revendications 1 à 4, dans laquelle chaque bloc de mémoire mémorise uniquement des bits provenant d'une seule position dans lesdits mots de données.

8. Mémoire de trames selon l'une quelconque des revendications précédentes, dans laquelle les premiers tampons (D0-D11) comprennent un circuit de verrouillage pipeline.

9. Mémoire de trames selon l'une quelconque des revendications précédentes, dans laquelle les seconds tampons (Q0-Q11) comprennent un circuit de verrouillage pipeline.

10. Mémoire de trames selon l'une quelconque des revendications précédentes, dans laquelle chacun de ladite pluralité de seconds circuits est en outre capable de transférer des bits d'un mot de données mémorisé dans un bloc de mémoire (30,31) à l'un associé de seconds tampons (Q0-Q11).

11. Mémoire de trames selon l'une quelconque des revendications 8 à 10, dans laquelle chaque bit dudit mot de données est chargé dans le bloc de mémoire par l'intermédiaire d'un seul ensemble de circuits de verrouillage pipeline.

12. Mémoire de trames selon l'une quelconque des revendications précédentes, dans laquelle ledit premier tampon (D0-D11) est couplé à une borne d'entrée, chaque borne d'entrée étant disposée au voisinage de l'un correspondant des blocs de mémoire (30,31), dans lequel le bit du mot de données doit être mémorisé.

13. Mémoire de trames selon l'une quelconque de revendications précédentes, dans laquelle le second tampon (Q0-Q11) est couplé à une borne de sortie, chaque borne de sortie étant disposée au voisinage de l'un correspondant des blocs de mémoire (30,31), dans lequel un bit du mot de données doit être mémorisé.

14. Mémoire de trames selon l'une quelconque des revendications précédentes, dans laquelle la borne d'entrée et la borne de sortie connectées au bloc de mémoire (30,31) associé à un bit d'un mot de données sont adjacentes.

15. Mémoire de trames selon l'une quelconque des revendications précédentes, dans laquelle la mémoire de trames constitue un dispositif conditionné.

16. Mémoire de trames selon la revendication 15, dans laquelle le dispositif prêt à installer comprend un module conducteur-sur-plaquette (LOC).

17. Mémoire de trames selon l'une quelconque des revendications précédentes comprenant en outre : un agencement masqué d'autorisation d'entrée (IE).
